# FASCICULE DE BREVET EUROPEEN

(11) **EP 1 475 726 B1**
(45) Date de publication et mention de la délivrance du brevet: **27.12.2017**
(21) Numéro de dépôt: 04290843.4
(22) Date de dépôt: 31.03.2004
(51) Int. Cl.: G06T 13/40, G06T 19/00, G06F 17/50

(54) **Système d'interface graphique**
Graphische Benutzeroberfläche
Graphical user interface

(30) Priorité: 09.04.2003 FR 0304377
(43) Date de publication de la demande: 10.11.2004
(73) Titulaire: SNECMA, 75015 Paris (FR)
(72) Inventeur: Maille, Bruno, 75015 Paris (FR); Ramstein, Edouard, 77000 Melun (FR); Chedmail, Patrick, 44240 La Chapelle-sur-Erdre (FR)
(74) Mandataire: Delumeau, François Guy

(56) Documents cités:
- EP-A2- 0 172 368
- US-A1- 2003 007 000
- MAILLE B ET AL: "Multi-agent approach and emergence of a virtual human behaviour in a vr environment" IEEE 2002 INTERNATIONAL CONFERENCE ON SYSTEMS, MAN AND CYBERNETICS. (SMC'02). YASMINE HAMMAMET, TUNESIA, OCT. 6 - 9, 2002, IEEE INTERNATIONAL CONFERENCE ON SYSTEMS, MAN, AND CYBERNETICS, NEW YORK, NY: IEEE, US, vol. 7 OF 7, 6 octobre 2002 (2002-10-06), pages 119-124, XP010625598 ISBN: 0-7803-7437-1
- RIFFARD V ET AL: "Optimal posture of a human operator and CAD in robotics" ROBOTICS AND AUTOMATION, 1996. PROCEEDINGS., 1996 IEEE INTERNATIONAL CONFERENCE ON MINNEAPOLIS, MN, USA 22-28 APRIL 1996, NEW YORK, NY, USA,IEEE, US, 22 avril 1996 (1996-04-22), pages 1199-1204, XP010162908 ISBN: 0-7803-2988-0
- PATRICK CHEDMAIL ET AL: "Accessibility and egonomics study with virtual reality, a state of the art", MECANIQUE ET INDUSTRIES, ELSEVIER, PARIS, FR, vol. 3, no. 2, 1 January 2002 (2002-01-01) , pages 147-152, XP002267500, ISSN: 1296-2139, DOI: 10.1016/S1296-2139(02)01151-X

## Description

### Domaine de l'invention

La présente invention se rapporte au domaine de la simulation d'opérations manuelles au moyen de mannequin virtuel. L'invention concerne plus particulièrement le paramétrage et la manipulation des membres d'un mannequin virtuel lors d'une telle simulation.

### Arrière plan de l'invention

Dans de nombreuses industries, telles que l'aéronautique ou l'aérospatiale, afin de minimiser les coûts et les délais de développement (prototypes, essai), on fait couramment appel à des représentations virtuelles de l'objet à concevoir. Une telle modélisation présente l'avantage d'être peu pénalisante (coûts, délai) vis à vis d'éventuels retours en arrière lors de la conception. La modélisation en réalité virtuelle de l'objet permet également d'effectuer toutes sortes de simulations utiles pour la validation de conception de celui-ci.

Toutefois, la modélisation et la simulation ne sont pas limitées seulement aux objets à concevoir. Elle peut être également utilisée pour simuler des actions humaines dans un environnement défini afin de visualiser les déplacements et les postures qu'un technicien devra réaliser pour effectuer les actions. Ceci est utile pour valider et optimiser l'accessibilité de certaines pièces d'un dispositif comme celles d'un moteur d'avion par exemple qui demandent des inspections et des maintenances régulières. Ainsi, la facilité d'accès des différents éléments d'un dispositif peut être contrôlée virtuellement dès la modélisation de ce dernier grâce à une simulation au moyen d'un mannequin virtuel.

L'utilisation d'un mannequin virtuel pour ce type d'application existe déjà comme c'est le cas avec le logiciel "Catia" de la société Dassault-Systèmes. Ce logiciel permet de réaliser des simulations à partir d'un mannequin virtuel que l'on anime en manipulant ses membres et en agissant sur les degrés de liberté associés à chaque membre. En effet, pour obtenir une simulation réaliste à partir d'un mannequin virtuel, il faut s'assurer que les mouvements de chaque membre s'effectuent en conformité avec les degrés de liberté qui sont attachés au membre considéré. De plus, suivant l'environnement (obstacle, position du mannequin, proximité de dangers pour l'opérateur), les degrés de liberté peuvent être encore plus limités. Il faut alors avoir la possibilité de bloquer/débloquer des membres ou certains de leurs degrés de liberté pour obtenir une simulation qui tient compte de l'environnement.

Dans la solution actuelle, la manipulation ou le blocage/déblocage des degrés de liberté d'un membre s'effectue degré par degré. En d'autres termes, pour chaque degré de liberté, on sélectionne ou édite celui-ci par un numéro, puis on choisit soit de le bloquer, soit de le manipuler. Une telle procédure est relativement lente et fastidieuse. En effet, on est limité à un degré de liberté à la fois pour la manipulation en cinématique directe. De plus, il faut connaître les degrés de liberté par leur numéro pour chaque articulation ce qui ne facilite pas le contrôle du paramétrage du mannequin.

### Objet et résumé de l'invention

La présente invention vise à remédier aux inconvénients précités et à réaliser un système qui facilite la tâche de l'opérateur lors du paramétrage et de la manipulation du mannequin en cinématique.

Ces buts sont atteints grâce à un système d'interface graphique avec les caractéristiques telles que définies dans la revendication 1.

Les caractéristiques du préambule sont connus de la demande EP 0 172 368 A2. Ainsi, grâce au système selon l'invention, l'opération de sélection d'un membre et de ses degrés de liberté se fait directement à l'écran à partir d'une représentation graphique du mannequin. L'opérateur n'a plus besoin de mémoriser ou consulter des numéros d'édition pour accéder à un degré de liberté particulier du mannequin. Les moyens de traitement réagissent au moyen de sélection, dans la seconde fenêtre, pour bloquer ou débloquer un degré de liberté, par sélection du symbole du degré de liberté correspondant. Le paramétrage des degrés de liberté se fait directement sur l'écran avec le moyen de sélection ce qui simplifie encore le travail de l'opérateur. De plus, les symboles des degrés de liberté bloqués sont affichés dans une couleur prédéterminée et les symboles des degrés de liberté qui sont débloqués sont affichés dans une autre couleur prédéterminée.

Le ou les membres dont au moins un degré de liberté est bloqué sont affichés dans une couleur prédéterminée dans la première fenêtre afin de distinguer les membres comportant des degrés de liberté désactivés.

Selon une caractéristique de l'invention, chaque symbole d'un degré de liberté comprend des première et seconde flèches, chaque flèche représentant un sens de rotation du degré de liberté. Les moyens de traitement réagissent au moyen de sélection pour bloquer un sens de rotation du degré de liberté par sélection de la flèche correspondante, ladite flèche étant alors affichée dans une couleur prédéterminée.

Selon un autre aspect de l'invention qui correspond au mode manipulation, les moyens de traitement réagissent au moyen de sélection, dans la seconde fenêtre, pour manipuler un degré de liberté du mannequin, la flèche sélectionnée correspondant au sens de manipulation du degré de liberté considéré. Dans ce mode, la flèche correspondant au sens de manipulation du degré de liberté est affichée dans une couleur prédéterminée selon que le degré de liberté est manipulé ou non. Lorsque le degré de liberté est manipulé dans un sens ou dans l'autre sur l'interface graphique, le degré de liberté correspondant sur le mannequin virtuel utilisé est déplacé dans le sens correspondant et à une vitesse déterminée.

Le ou les membres dont au moins un degré de liberté est manipulé sont affichés dans une couleur prédéterminée dans la première fenêtre afin de distinguer les membres comportant des degrés de liberté manipulés.

Suivant encore une autre caractéristique de l'invention, les moyens de traitement réagissent au moyen de sélection, dans la première fenêtre, pour activer ou désactiver un membre et afficher les membres actifs dans une couleur prédéterminée et les membres désactivés dans une autre couleur prédéterminée. Cette première fenêtre permet également de sélectionner le membre qui sera affiché en détail avec ses degrés de liberté dans une seconde fenêtre.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels:
- la figure 1 est une vue en perspective des moyens matériels mis en oeuvre dans le système d'interface de l'invention,
- la figure 2 montre un premier exemple d'utilisation du système d'interface de l'invention,
- la figure 3 montre un second exemple d'utilisation du système d'interface de l'invention,
- la figure 4 montre un troisième exemple d'utilisation du système d'interface de l'invention, et
- les figures 5A, 5B et 5C montrent la visualisation, sur un mannequin virtuel, du résultat des actions réalisées dans le troisième exemple d'utilisation du système d'interface illustré en figure 4.

### Description détaillée d'un mode de réalisation

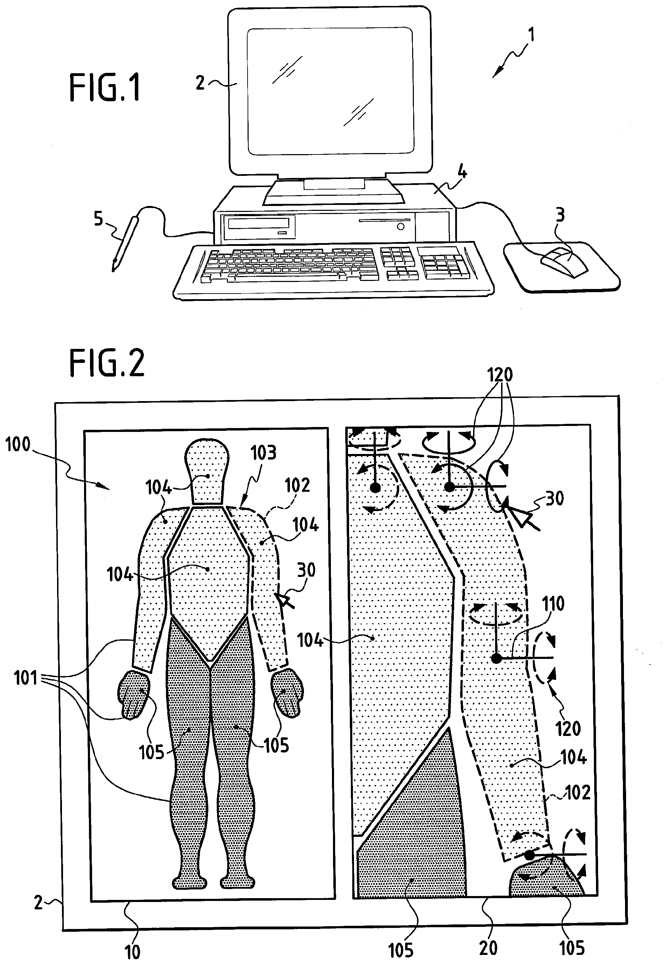

La figure 1 représente le système selon la présente invention qui comprend un appareil de traitement, tel qu'un ordinateur 1. L'ordinateur 1 peut être utilisé pour l'exécution d'un programme de simulation ou similaire pour visualiser les positions et déplacements d'un mannequin en réalité virtuelle. Par souci de simplification, le programme de simulation lui-même ne sera pas décrit plus en détail, ce programme n'étant pas l'objet de l'invention. En effet, l'invention concerne les moyens de visualisation, de sélection, de paramétrage et de manipulation des membres du mannequin virtuel qui pourront être utilisés dans un programme de simulation de réalité virtuelle. En d'autres termes, l'invention propose une interface graphique qui permet à un utilisateur de manipuler ou paramétrer les membres d'un mannequin virtuel.

L'ordinateur 1 comprend les moyens matériels que l'on trouve habituellement avec ce type d'appareil. Plus particulièrement, l'ordinateur comprend un écran 2, un moyen pour viser un point sur l'écran et agir sur lui, tel qu'une souris 3, un crayon optique 5 ou similaire, et une unité de traitement 4 qui commande l'affichage sur l'écran 2 notamment en réponse aux actions effectuées avec la souris 3 ou un autre moyen équivalent comme décrit ci-dessous.

La figure 2 illustre un premier exemple de mise en oeuvre du système selon l'invention. Cette figure montre la représentation sur l'écran 2 qui est faite du mannequin selon l'invention pour permettre à un utilisateur de manipuler et paramétrer les membres du mannequin. A cet effet, l'unité de traitement 4 exécute en premier lieu l'affichage d'une première fenêtre 10 dans laquelle un mannequin 100 est représenté en entier. Chaque membre (dans l'exemple ici considéré: tête, buste, bras, mains et jambes) qui peut être sélectionné est délimité par un contour fermé 101 d'une couleur prédéterminée, comme du noir par exemple. Ainsi, la représentation du mannequin dans la première fenêtre 10 correspond à la vue globale du mannequin qui donne une vue d'ensemble des membres qui peuvent être sélectionnés.

A partir de cette première image, un opérateur va pouvoir effectuer des actions directement sur le mannequin représenté dans la fenêtre 10 au moyen de la souris. La flèche 30 représente le pointeur de la souris que l'opérateur va déplacer sur le mannequin afin de désigner un membre qu'il souhaite sélectionner. Une fois la flèche 30 en position sur le membre choisit, ici le bras gauche 102, l'opérateur sélectionne le membre en cliquant sur un bouton de la souris par exemple. Pour indiquer à l'opérateur quel est le membre sélectionné, la couleur du contour 101 de celui-ci peut être changée en une couleur prédéterminée 102 (en traits discontinus sur les figures) pour le distinguer des autres membres qui ne sont pas sélectionnés. Lorsqu'un membre est sélectionné, l'opérateur a le choix entre deux opérations principales: activation/désactivation du membre dans son ensemble ou sélection du membre pour paramétrer et/ou manipuler certains degrés de liberté de celui-ci. La première opération, qui consiste à activer/désactiver le membre, s'effectue directement sur le mannequin représenté dans la fenêtre 10, par une commande correspondante qui peut être programmée sur une touche du clavier de l'ordinateur ou contenue dans un menu affiché à l'écran (non représenté) en même temps que le mannequin. Les membres activés sont représentés dans une couleur prédéterminée 104 (en ombrage clair sur les figures), comme le vert par exemple, alors que les membres désactivés sont représentés dans une autre couleur 105 (en ombrage foncé sur les figures) comme du rouge par exemple. Dans la fenêtre 10 telle qu'illustrée sur la figure 2, les jambes et les mains du mannequin qui sont désactivées sont en rouge (ombrage foncé sur les figures) alors que les bras et la tête qui sont activés sont en vert (ombrage clair sur les figures).

Lorsqu'un membre est sélectionné, il est affiché en détail dans une seconde fenêtre 20 pour permettre à l'opérateur d'effectuer la seconde opération mentionnée ci-dessus selon deux modes: le mode paramétrage ou le mode manipulation de certaines articulations du membre sélectionné. Chaque mode peut être activé après la sélection du membre à partir d'une touche du clavier ou d'un menu affiché à l'écran par exemple.

Sur la figure 2, on décrit l'opération en mode paramétrage des degrés de liberté d'un membre sélectionné. Dans la deuxième fenêtre 20, le membre sélectionné 103, à savoir le bras gauche, est représenté en vue agrandie pour indiquer à l'opérateur tous les degrés de liberté qui sont disponibles sur les articulations du membre sélectionné. A cet effet, les degrés de liberté du membre sont représentés sous forme d'un axe 110 dans le plan ou perpendiculaire au plan, et d'une double-flèche 120 représentant la rotation autour de cet axe dans les deux sens de rotation. Ainsi, au moyen de la flèche 30 de la souris, l'opérateur se positionne sur la double-flèche du degré de liberté qu'il souhaite paramétrer et clique sur cette dernière pour bloquer (respectivement débloquer) le degré de liberté considéré. Si l'opérateur clique de nouveau sur la double-flèche, ceci annule l'opération de blocage du degré de liberté. Ainsi, par une simple pression sur le bouton de la souris, l'opérateur peut bloquer/débloquer n'importe quel degré de liberté du membre sélectionné et ceci directement sur la représentation graphique du membre à l'écran.

Comme pour l'activation/désactivation des membres du mannequin vue plus haut, un code de couleur est utilisé pour distinguer sur la représentation à l'écran les degrés de liberté qui sont bloqués des degrés de liberté qui ne le sont pas. Plus précisément, lorsque l'opérateur bloque un degré de liberté, la double-flèche correspondante 120 devient rouge (en traits pleins sur la figure).

D'une manière générale, en mode paramétrage des degrés de liberté, les doubles-flèches sont en vert par défaut (traits discontinus sur la figure), c'est à dire que les degrés de liberté sont tous débloqués au départ.

Ainsi, pour les degrés de liberté qui ne sont pas bloqués à l'origine ou que l'opérateur a débloqués par la suite, la double-flèche correspondante 120 est en vert (en traits discontinus sur la figure). A titre d'exemple, sur la figure 2, on peut voir que tous les degrés de liberté de l'épaule ont été bloqués et sont en rouge (i.e. les trois doubles-flèches 120 de l'épaule en traits continus).

Grâce aux deux fenêtres 10 et 20 qui sont affichées simultanément à l'écran, l'opérateur dispose en permanence d'une vue d'ensemble du mannequin (fenêtre 10) qui lui indique les membres bloqués/débloqués ainsi que le membre sélectionné tout en ayant une vue détaillée (fenêtre 20) du membre sélectionné avec tous les degrés de liberté qu'il peut paramétrer. Lorsqu'au moins un degré de liberté est désactivé sur un membre, celui-ci est affiché dans la fenêtre 10 avec une couleur prédéfinie permettant de distinguer les membres comportant des degrés de liberté désactivés.

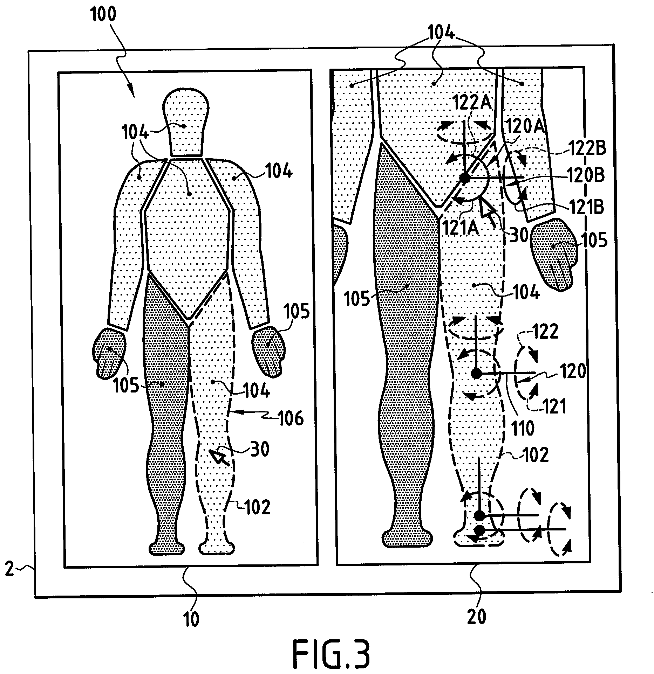

La figure 3 illustre un autre exemple de mise en oeuvre de l'interface graphique de l'invention pour le paramétrage des degrés de liberté de la jambe gauche 106 du mannequin 100. Dans cet exemple, l'opérateur a donc sélectionné la jambe 106 de sorte qu'une vue agrandie de cette dernière est visualisée dans la seconde fenêtre 20. comme décrit précédemment en relation avec la figure 2, on a vu que le blocage ou le déblocage d'un degré de liberté s'effectue en cliquant sur la double-flèche 120 considérée qui, selon son état (i.e. bloqué ou débloqué), était représentée dans une couleur prédéterminée. Toutefois, il est aussi possible de bloquer partiellement un degré de liberté, c'est à dire de bloquer un des deux sens de rotation de celui-ci. Dans ce cas, comme illustré sur la figure 3, les moyens de traitement sont programmés pour reconnaître sur chaque double-flèche 120 deux parties 121 et 122 correspondant respectivement à un sens de rotation du degré de liberté considéré. Sur la figure 3, l'opérateur clique sur la partie 121A de la flèche 120A. Ceci a pour effet de bloquer le degré de liberté dans le sens indiqué par la partie 121A qui est alors représentée en rouge (en traits pleins sur la figure). La partie 122A qui n'est pas bloquée reste en vert (en trait discontinus sur la figure). Sur la figure, on voit par exemple que le degré de liberté représenté par la double-flèche 120B a été aussi partiellement bloqué, la partie 121B étant représentée en rouge (en traits pleins sur la figure) alors que la partie 122B est en vert (en trait discontinus sur la figure).

On décrit maintenant, les opérations qui peuvent être réalisées sur le membre sélectionné en mode manipulation. Dans ce mode, la représentation du membre sélectionné dans la fenêtre 20 est utilisée pour manipuler les degrés de liberté en cinématique directe. De même que pour le blocage/déblocagepartiel des degrés de liberté décrit ci-dessus, chaque double flèche 120 comprend deux parties 121, 122 correspondant chacune à un sens de rotation du degré de liberté. Ainsi, pour la manipulation d'un degré de liberté, l'opérateur agit de la même façon que dans l'exemple considéré en figure 3. L'opérateur positionne la flèche de la souris 30 sur la partie de la double-flèche qui correspond au sens de rotation dans lequel il souhaite manipuler la partie du membre concerné. En cliquant sur la partie de la double flèche-choisie, il donne la consigne de déplacement au mannequin pour ce degré de liberté.

Lorsqu'au moins un degré de liberté est manipulé sur un membre, celui-ci est affiché dans la fenêtre 10 avec une couleur prédéfinie permettant de distinguer les membres comportant des degrés de liberté manipulés.

Dans le mode manipulation, les doubles-flèches sont en rouge par défaut (traits continus sur la figure), c'est à dire que les degrés de liberté sont tous non manipulés au départ.

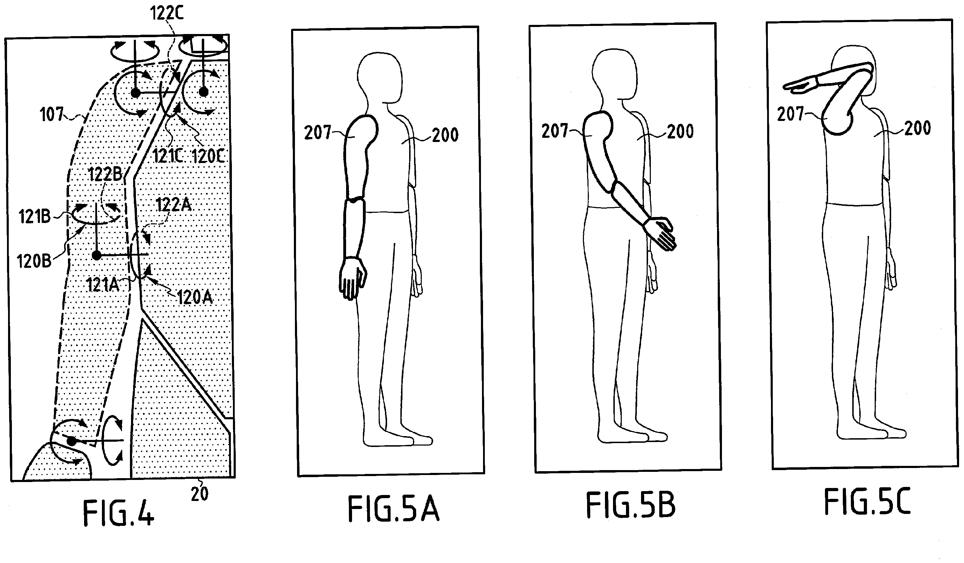

Un exemple de manipulation en cinématique directe est maintenant décrit en relation avec la figure 4, d'une part, qui illustre la deuxième fenêtre 20 de l'interface graphique, et, d'autre part, les figures 5A, 5B et 5C qui sont des visualisations d'un mannequin virtuel 200 sur lequel sont appliquées les consignes de déplacement générées à partir de l'interface graphique de la figure 4. La visualisation des mouvements sur le mannequin virtuel dans son environnement de simulation est effectuée par un programme de simulation spécifique qui comprend des liens avec le programme de l'interface graphique de l'invention. Ainsi, les données générées à partir de l'interface graphique sont transmises et utilisées par le programme de simulation pour l'animation du mannequin virtuel.

Les figures 5A à 5C illustrent une séquence de cinématique d'un mannequin virtuel 200 en fonction des consignes de mouvement appliquées à partir de l'interface graphique de la figure 4. Sur cette figure, le bras droit 107 du mannequin est affiché dans la fenêtre 20 et les consignes de déplacement sont appliquées par l'opérateur en sélectionnant successivement les parties 122A, 122B et 122C des doubles-flèches 120A, 120B et 120C respectivement. La sélection des parties 122A, 122B et 122C correspond respectivement à l'action de pliage du bras, de rotation de l'avant-bras et de la rotation de l'épaule dans le sens correspondant et à une vitesse déterminée. Une fois ces trois degrés manipulés dans l'interface graphique, le mannequin se dirige alors vers la position illustrée en figure 5C.

La consigne de déplacement donnée par l'opérateur est également indiquée dans la fenêtre 20 par le changement de couleur de la partie de la double-flèche sélectionnée. Sur la figure 4, les parties 122A, 122B et 122C des doubles-flèches 120A, 120B et 120C sur lesquelles l'opérateur a cliqué deviennent vertes (en traits discontinus sur la figure).

La figure 5B illustre une position intermédiaire du bras 207 du mannequin virtuel 200 entre la position de départ (figure 5A) et la position finale de la séquence cinématique (figure 5C) lorsque la consigne de déplacement est donnée au niveau de l'articulation du bras et de l'épaule en cliquant sur les parties 122A et 122C des doubles-flèches 120A et 120C.

Si l'opérateur clique une nouvelle fois sur la même partie d'une double-flèche, la consigne de déplacement pour le degré de liberté considéré est annulée. Le mannequin virtuel maintient alors ce degré de liberté dans sa position courante lors de l'annulation de cette consigne de déplacement et la partie de la double-flèche concernée redevient rouge (en traits pleins sur la figure).

L'invention propose donc un système d'interface graphique qui permet à l'opérateur de sélectionner et d'agir sur les degrés de liberté du mannequin directement à l'écran et par de simples opérations comme un clic de souris par exemple. Le confort de travail de l'opérateur est en outre amélioré par le double fenêtrage affiché qui lui permet en permanence de disposer à la fois de la représentation globale du mannequin et d'une vue détaillée du membre sur lequel il travaille.

## Revendications

1. Système d'interface graphique, comportant
un moyen de visualisation (2),
un moyen de sélection (30) pour désigner un point sur le moyen de visualisation et agir sur lui, et
des moyens de traitement (4) pour commander, sur le moyen de visualisation (2), l'affichage dans une première fenêtre (10) d'un objet, lesdits moyens de traitement réagissant au moyen de sélection pour commander en outre l'affichage, dans une seconde fenêtre (20), d'un membre sélectionné à partir de l'objet affiché dans la première fenêtre (10),
**caractérisé en ce que**
ledit système d'interface graphique est pour la gestion des degrés de liberté d'un mannequin virtuel dans un environnement cinématique, ledit mannequin comportant des membres articulés selon des degrés de liberté,
ledit objet est ledit mannequin,
ledit membre comporte des symboles (120) indiquant les degrés de liberté dudit membre sélectionné, et les moyens de traitement réagissent au moyen de sélection, dans la seconde fenêtre (20), pour bloquer ou débloquer un degré de liberté, par sélection du symbole (120) du degré de liberté correspondant.

2. Système selon la revendication 1, dans lequel le ou les membres dont au moins un degré de liberté est bloqué sont affichés dans une couleur prédéterminée dans la première fenêtre.

3. Système selon la revendication 1 ou 2, dans lequel les symboles des degrés de liberté bloqués sont affichés dans une couleur prédéterminée et les symboles des degrés de liberté qui sont débloqués sont affichés dans une autre couleur prédéterminée.

4. Système selon l'une quelconque des revendications 1 à 3, dans lequel chaque symbole (120) d'un degré de liberté comprend des première et seconde flèches (121, 122), chaque flèche représentant un sens de rotation du degré de liberté.

5. Système selon la revendication 4, dans lequel les moyens de traitement réagissent au moyen de sélection pour bloquer un sens de rotation du degré de liberté par sélection de la flèche correspondante, ladite flèche étant alors affichée dans une couleur prédéterminée.

6. Système selon la revendication 4, dans lequel les moyens de traitement réagissent au moyen de sélection, dans la seconde fenêtre (20), pour manipuler un degré de liberté du mannequin, la flèche sélectionnée correspondant au sens de manipulation du degré de liberté considéré.

7. Système selon la revendication 6, dans lequel le ou les membres dont au moins un degré de liberté est manipulé sont affichés dans une couleur prédéterminée dans la première fenêtre.

8. Système selon la revendication 6 ou 7, dans lequel, dans la seconde fenêtre (20), la flèche correspondant au sens de manipulation du degré de liberté est affichée dans une couleur prédéterminée.

9. Système selon l'une quelconque des revendications 1 à 8, dans lequel les moyens de traitement réagissent au moyen de sélection, dans la première fenêtre (10), pour activer ou désactiver un membre et afficher les membres actifs dans une couleur prédéterminée (104) et les membres désactivés dans une autre couleur prédéterminée (105).

10. Système selon l'une quelconque des revendications 1 à 9, dans lequel les moyens de traitement affichent le contour du membre sélectionné dans une couleur prédéterminée (102).

## Patentansprüche

1. Graphisches Schnittstellensystem, umfassend
ein Anzeigemittel (2),
ein Auswahlmittel (30), um eine Stelle auf dem Anzeigemittel zu bestimmen und auf diese zu wirken, und
Verarbeitungsmittel (4), um auf dem Anzeigemittel (2) die Anzeige eines Objektes in einem ersten Fenster (10) zu steuern, wobei die Verarbeitungsmittel auf das Auswahlmittel reagieren, um ferner die Anzeige einer Gliedmaße, die aus dem in dem ersten Fenster (10) angezeigten Objekt ausgewählt ist, in einem zweiten Fenster (20) zu steuern,
**dadurch gekennzeichnet, dass** das graphische Schnittstellensystem zur Steuerung der Freiheitsgrade einer virtuellen Gliederpuppe in einer kinematischen Umgebung ist, wobei die Gliederpuppe Gliedmaßen, die in Freiheitsgraden gelenkig sind, aufweist, das Objekt die Gliederpuppe ist, die Gliedmaße Symbole (120) umfasst, welche die Freiheitsgrade der ausgewählten Gliedmaße angeben, und die Verarbeitungsmittel auf das Auswahlmittel in dem zweiten Fenster (20) reagieren, um durch Auswahl des Symbols (120) des entsprechenden Freiheitsgrades einen Freiheitsgrad zu sperren oder freizugeben.

2. System nach Anspruch 1, bei dem die Gliedmaße oder Gliedmaßen, von denen wenigstens ein Freiheitsgrad gesperrt ist, in einer vorbestimmten Farbe in dem ersten Fenster angezeigt werden.

3. System nach Anspruch 1 oder 2, bei dem die Symbole der gesperrten Freiheitsgrade in einer vorbestimmten Farbe angezeigt werden und die Symbole der Freiheitsgrade, die freigegeben sind, in einer anderen vorbestimmten Farbe angezeigt werden.

4. System nach einem der Ansprüche 1 bis 3, bei dem jedes Symbol (120) eines Freiheitsgrades einen ersten und einen zweiten Pfeil (121, 122) umfasst, wobei jeder Pfeil eine Drehrichtung des Freiheitsgrades darstellt.

5. System nach Anspruch 4, bei dem die Verarbeitungsmittel auf das Auswahlmittel reagieren, um durch Auswahl des entsprechenden Pfeils eine Drehrichtung des Freiheitsgrades zu sperren, wobei der Pfeil dann in einer vorbestimmten Farbe angezeigt wird.

6. System nach Anspruch 4, bei dem die Verarbeitungsmittel auf das Auswahlmittel in dem zweiten Fenster (20) reagieren, um einen Freiheitsgrad der Gliederpuppe zu manipulieren, wobei der ausgewählte Pfeil der Manipulationsrichtung des betrachteten Freiheitsgrades entspricht.

7. System nach Anspruch 6, bei dem die Gliedmaße oder Gliedmaßen, von denen wenigstens ein Freiheitsgrad manipuliert wird, in einer vorbestimmten Farbe in dem ersten Fenster angezeigt werden.

8. System nach Anspruch 6 oder 7, bei dem in dem zweiten Fenster (20) der Pfeil, welcher der Manipulationsrichtung des Freiheitsgrades entspricht, in einer vorbestimmten Farbe angezeigt wird.

9. System nach einem der Ansprüche 1 bis 8, bei dem die Verarbeitungsmittel auf das Auswahlmittel in dem ersten Fenster (10) reagieren, um eine Gliedmaße zu aktivieren oder zu deaktivieren und um die aktiven Gliedmaßen in einer vorbestimmten Farbe (104) und die deaktivierten Gliedmaßen in einer anderen vorbestimmten Farbe (105) anzuzeigen.

10. System nach einem der Ansprüche 1 bis 9, bei dem die Verarbeitungsmittel die Kontur der ausgewählten Gliedmaße in einer vorbestimmten Farbe (102) anzeigen.

## Claims

1. A graphical interface system for managing degrees of freedom of a virtual dummy in a dynamic environment, said dummy comprising jointed members with degrees of freedom, the system comprising:
• display means (2);
• pointer means (30) for designating a point on the display means and for acting thereon; and
• processor means (4) for causing the display means (2) to display an object in a first window (10), said processor means responding to the pointer means to cause a second window (20) to display a selected member of the object displayed in the first window (10), **characterized in that** said graphical interface system is for managing degrees of freedom of a virtual dummy in a dynamic environment, said dummy comprising jointed members with degrees of freedom, said object being the dummy, said selected member including symbols (120) indicating the degrees of freedom of said selected member, and the processor means respond to the pointer means selecting the symbol (120) for a degree of freedom in the second window (20), by blocking or unblocking the corresponding degree of freedom.

2. A system according to claim 1, wherein the members having at least one degree of freedom that is blocked are displayed in a predetermined color in the first window.

3. A system according to claim 1 or 2, wherein the symbols for blocked degrees of freedom are displayed in one predetermined color and the symbols for degrees of freedom that are unblocked are displayed in another predetermined color.

4. A system according to any one of claims 1 to 3, wherein each symbol (120) of a degree of freedom comprises first and second arrows (121, 122), each arrow indicating a direction of rotation of the degree of freedom.

5. A system according to claim 4, wherein the processor means respond to the pointer means selecting an arrow corresponding to a direction of rotation for a degree of freedom, by blocking that degree of freedom, said arrow then being displayed in a predetermined color.

6. A system according to claim 4, wherein the processor means respond to the pointer means selecting an arrow in the second window (20) corresponding to a direction in which a degree of freedom is manipulated, by manipulating that degree of freedom of the dummy.

7. A system according to claim 6, wherein the members having at least one degree of freedom that has been manipulated are displayed in a predetermined color in the first window.

8. A system according to claim 6 or 7, wherein, in the second window (20), the arrow corresponding to the direction of manipulation of the degree of freedom is displayed in a predetermined color.

9. A system according to any one of claims 1 to 8, wherein the processor means respond to the pointer means selecting a member, in the first window (10), by activating or deactivating that member and by displaying the activated members in one predetermined color (104) and the deactivated members in another predetermined color (105).

10. A system according to any one of claims 1 to 9, wherein the processor means display the outline of the selected member in a predetermined color (102).
